**Europäisches Patentamt**

**European Patent Office**

**Office européen des brevets**

(11) Publication number: **0 060 115**

**B1**

(12) **EUROPEAN PATENT SPECIFICATION**

(45) Date of publication of patent specification: **25.11.87**

(51) Int. Cl.⁴: **G 11 C 11/40**

(21) Application number: **82301156.4**

(22) Date of filing: **08.03.82**

(54) **Static RAM memory circuit.**

(30) Priority: **09.03.81 JP 33475/81**

(43) Date of publication of application:
**15.09.82 Bulletin 82/37**

(45) Publication of the grant of the patent:
**25.11.87 Bulletin 87/48**

(84) Designated Contracting States:
**DE FR GB**

(56) References cited:
**US-A-3 765 002**

**PATENTS ABSTRACTS OF JAPAN, vol. 1, no.
163, December 22, 1977, page 9225 E 77
PATENTS ABSTRACTS OF JAPAN, vol. 3, no.
26 (E-95), March 6, 1979, page 9 E95
PATENTS ABSTRACTS OF JAPAN, vol. 3, no.
135 (E-150), November 10, 1979, page 100 E 150
IEEE Journal of Solid State Circuits, vol. SC-15,
1980, oct., no. 5, pages 854-861**

(73) Proprietor: **FUJITSU LIMITED
1015, Kamikodanaka Nakahara-ku
Kawasaki-shi Kanagawa 211 (JP)**

(72) Inventor: **Oritani, Atsushi
37-22, Kibogaoka Asahi-ku
Yokohama-shi Kanagawa. 241 (JP)**

(74) Representative: **Sunderland, James Harry et al
HASELTINE LAKE & CO Hazlitt House
28 Southampton Buildings Chancery Lane
London WC2A 1AT (GB)**

Courier Press, Leamington Spa, England.

## Description

The present invention relates to a static RAM (Random Access Memory) memory circuit.

When the memory density of a static RAM is high, the size of each cell of the RAM used for storing data inevitably becomes small. Since a cell of an ordinary static RAM comprises a flip-flop circuit, small cell size results in reduction of transconductances $g_m$ of MIS field effect transistors (which are hereinbelow referred to as MOS FET's) used as a cell driver.

In order to achieve a satisfactory memory cell function (to cause a transistor on the "ON" side of the cell to pull down a corresponding bit line), the current flowing through a load for pulling up the bit line (tending to pull up the bit line) must be reduced. By way of example, when a MOS FET is used as a load, its transconductance $g_m$ must be reduced. However, this involves a degradation in the charging ability in respect of the bit line; that is, a reduction in the rate at which the bit line can be changed from a low level to a high level, so that a rise of the potential of the bit line becomes slow. In these conditions it is difficult to provide fast operation for a high-density static RAM.

Attention is directed to the following prior art documents:—

D1: Patents Abstracts of Japan, vol. 1, No. 163; 22 December 1977, page 9225E-77; and JP—A—52 110 530.

D2: US—A—3 765 002.

D3: Patents Abstracts of Japan, vol. 3, No. 26 (E-95); 6 March 1979, page 9E95; and JP—A—544 029.

D4: IEEE Journal of Solid State Circuits, vol. SC-15; No. 5, October 1980, pages 854—861.

D5: Patents Abstracts of Japan, vol. 3, No. 135 (E-150), 10 November 1979, page 100E150; and JP—A—54 113 222.

D1 discloses an arrangement in which, in a RAM using MOS transistors, outputs of transistors connected to digit lines are fed back via a latch circuit and NAND gates to digit line load transistors.

D2 discloses a discharging circuit for discharging a bit line of an MOS memory.

D3 discloses a symmetrical differential amplifying circuit for an asynchronous complementary type RAM.

D4 (see Figure 7) discloses memory and sense amplifier circuitry of a static MOS RAM.

D5 concerns a static type MIS memory and a circuit for reducing power consumption when writing.

According to the present invention, there is provided a static RAM including a memory circuit comprising: a pair of bit lines, to which pull-up loads are respectively connected; a plurality of memory cells each connected to the pair of bit lines; a pair of data bus lines operatively connected to the pair of bit lines, and a sense amplifier connected to the pair of bit lines through the pair of data bus lines, characterised in that the sense amplifier comprises a linear amplifier which delivers complementary outputs and in that the memory circuit further comprises charging circuitry operatively connected to the pair of data bus lines for charging up that one of the pair of data bus lines which is of higher potential, the charging circuitry having control terminals arranged to receive respectively and directly the complementary outputs of the sense amplifier and being activated in dependence upon the said outputs.

An embodiment of the present invention can provide a high-density static RAM capable of fast operation.

In an embodiment of the present invention it is provided that current flowing through a load of a data bus line, which line may be regarded as equivalent to a bit line in terms of potential changes etc. because it is connected to the bit line through a column selecting gate, (the load being a pull-up FET for example) in other words a charging current, is changed in dependence upon a signal read out.

Reference is made, by way of example, to the accompanying drawings, in which:—

Figure 1 is a circuit diagram illustrating an embodiment of the present invention,

Figure 2 is a graph showing characteristic curves indicating dependence of signal voltages upon supply voltage in the circuit of Figure 1, and

Figure 3A is a waveform diagram showing signals developed in a previously proposed circuit, whilst Figure 3B is a waveform diagram showing signals developed in the embodiment of the present invention illustrated in Figure 1.

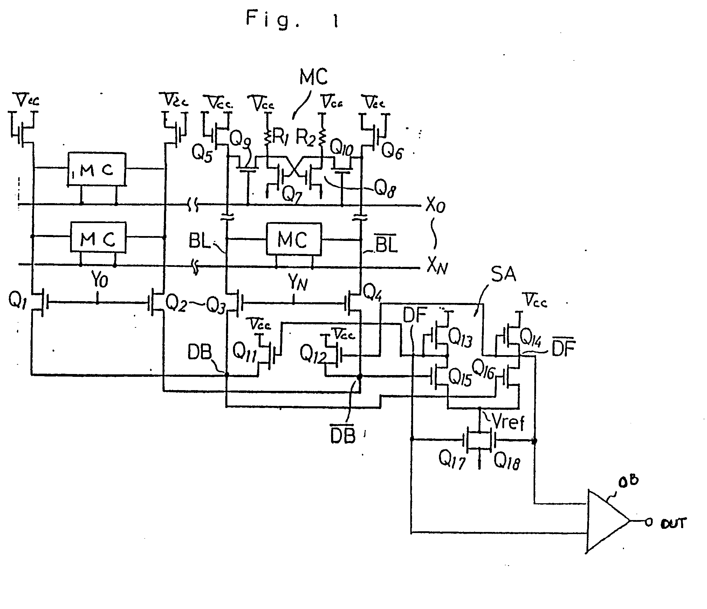

Figure 1 illustrates an embodiment of the present invention. In Figure 1, MC indicates memory cells, and SA is a sense amplifier. $X_0$—$X_N$ are word lines, and $Y_0$—$Y_N$ are column selecting signal lines. $Q_1$—$Q_4$ are MOS FET's forming column selecting gates, and $Q_5$ and $Q_6$ are MIS FET's (hereinafter referred to as MOS FET's) which are as bit line loads. $Q_7$ and $Q_8$ are MOS FET's which constitute a cell driver, and are respectively provided with load elements (resistors) $R_1$ and $R_2$. $Q_9$ and $Q_{10}$ are MOS FET's which function as transfer gates. BL and $\overline{BL}$ are a bit line pair, and DB and $\overline{DB}$ are a pair of data bus lines. $Q_{11}$ and $Q_{12}$ are MOS FET's of charging circuits for charging the data bus lines DB and $\overline{DB}$, respectively.

The sense amplifier SA is a differantial amplifier comrising two inverters made up of depletion-mode load MOS FET's $Q_{13}$ and $Q_{14}$ and enhancement-mode driving MOS FET's $Q_{15}$ and $Q_{16}$. The sources of MOS FET's $Q_{15}$ and $Q_{16}$ are connected in common. $Q_{17}$ and $Q_{18}$ are MOS FET's which are connected in parallel with one another to the common-connected sources of $Q_{15}$ and $Q_{16}$. Outputs DF and $\overline{DF}$ (of the inverters) are fed back to the MOS FET's $Q_{17}$ and $Q_{18}$, to correct a reference voltage $V_{ref}$ (at their common connection point with the sources of $Q_{15}$ and $Q_{16}$) to provide an appropriate value at all times so that a linear operation is effected.

An input of the sense amplifier SA on the side of the MOS FET $Q_{15}$ is the potential of the data bus line $\overline{DB}$, whilst an input of the sense amplifier SA on the side of the MOS FET $Q_{16}$ is the potential of the data bus line DB.

An amplified output DF, of the same polarity as the potential of the data bus line DB, is obtained from the drain side of the MOS FET $Q_{15}$, and is fed back to the gate of the MOS FET $Q_{11}$. On the other hand, an amplified output $\overline{DF}$, of the same polarity as the potential of the data bus line $\overline{DB}$, is obtained from the drain side of the MOS FET $Q_{16}$, and is fed back to the gate of the MOS FET $Q_{12}$.

$V_{cc}$ signifies a power source voltage, and a downwardly pointing arrow signifies ground.

In the sense amplifier SA, the outputs DF and $\overline{DF}$ are respectively fed back to the gates of the MOS FET's $Q_{17}$ and $Q_{18}$. Briefly, therefore, the reference voltage $V_{ref}$ can become a virtual ground or a constant voltage with respect to the inputs DB and $\overline{DB}$.

The reference voltage $V_{ref}$ is in phase with supply voltage: that is to say, the reference voltage $V_{ref}$ rises with an increase in supply voltage ($V_{cc}$) and falls with a decrease in power source voltage.

When an input signal $\overline{DB}$ (here, signals will be indicated by the same symbols as are used for the respective lines carrying those signals) of the MOS FET $Q_{15}$ has changed to the high level ("H") side (increased) and the input signal DB of the MOS FET $Q_{16}$ has changed to the low level ("L") side (decreased), the output potential DF falls and the output potential $\overline{DF}$ rises. Upon receiving these outputs $\overline{DF}$ and DF, the conduction of MOS FET $Q_{17}$ falls whilst the conduction of the MOS FET $Q_{18}$ rises. The combined resistance formed by the parallel transistors $Q_{17}$ and $Q_{18}$ is substantially invariable. Accordingly, the reference voltage $V_{ref}$ remains constant.

In contrast, if the input voltages of both MOS FET's $Q_{15}$ and $Q_{16}$ have increased, conductions of both transistors $Q_{17}$ and $Q_{18}$ fall, so that the reference voltage $V_{ref}$ rises. Further, if the input voltages of both MOS FETs $Q_{15}$ and $Q_{16}$ have decreased, conductions of both transistors $Q_{17}$ and $Q_{18}$ rise, so that the reference voltage $V_{ref}$ falls.

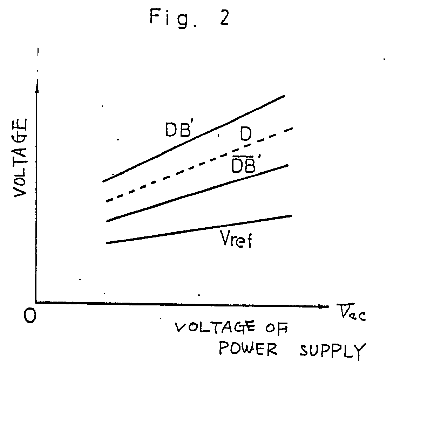

The relationships of voltages DB, $\overline{DB}$ and $V_{ref}$ (and their dependence upon power supply $V_{cc}$), are illustrated in Figure 2, in which voltage DB' (on data bus line DB) is a high level data bus voltage, whilst voltage $\overline{DB}$' (on data bus line $\overline{DB}$) is a low level data bus voltage. In the graph of Figure 2 supply voltage $V_{cc}$ is represented as abscissa, whilst voltages DB' and $\overline{DB}$' and the reference voltage $V_{ref}$ are represented as ordinate. It will be noted that the data bus line potentials vary in phase with variations in $V_{cc}$ as indicated in Figure 2.

In order for the sense amplifier SA to provide linear operation, a value obtained by adding the reference voltage $V_{ref}$ and the source-drain voltage of each MOS FET $Q_{15}$ or $Q_{16}$ needs to lie between the voltages DB' and $\overline{DB}$'. As will be apparent from Figure 2, this aforementioned value for the sense amplifier SA shown in Figure 1 is indicated by a broken line D in Figure 2. Therefore, the MOS FET's $Q_{15}$ and $Q_{16}$ constituting a differential amplifier, execute a linear operation.

Accordingly, in a case in which potentials of the inputs DB and $\overline{DB}$ have fluctuated, even slightly, this differential amplifier generates amplified outputs DF and $\overline{DF}$ which follow up the fluctuations. That is, the amplifier operates as an analog linear amplifier in which, when the input DB changes from "L" (low level) to "H" (high level) and the input $\overline{DB}$ changes from "H" to "L", the output $\overline{DF}$ rapidly shifts from "H" to "L" and the output DF rapidly shifts from "L" to "H".

Further, the outputs DF and $\overline{DF}$ are respectively fed back to the gates of the MOS FETs $Q_{11}$ and $Q_{12}$ in the same polarity (with unchanged polarities). Thus, the potential changes of a data bus line and a bit line which are shifting from "L" to "H", for example DB and BL, are promoted by charging using the MOS FET $Q_{11}$ (DF) and are therefore effected quickly. This is equivalent to temporarily increasing the transconductance $g_m$ of the bit line load transistor $Q_5$ (of bit line BL) during charging.

On the other hand, with respect to potential changes of the data bus line and the bit line $\overline{DB}$ and $\overline{BL}$ which are shifting from "H" to "L", the MOS FET $Q_{12}$ has its gate supplied with the amplified output DB ($\overline{DF}$), which is changing from "H" to "L", and turns "OFF". Therefore, the discharging characteristics of the data bus line $\overline{DB}$ and the biz line $\overline{BL}$ are those based only on the bit line load MOS FET $Q_6$ and are unaffected by $Q_{12}$. Since the transconductance $G_M$ OF THE MOS FET $Q_6$ remains low, the pull-down of the data bus line and bit line is satisfactorily effected by the cell driver MOS FET $Q_8$.

In Figure 1 OB is an output buffer which receives the signals DF, $\overline{DF}$ and outputs a read out signal to an output terminal OUT.

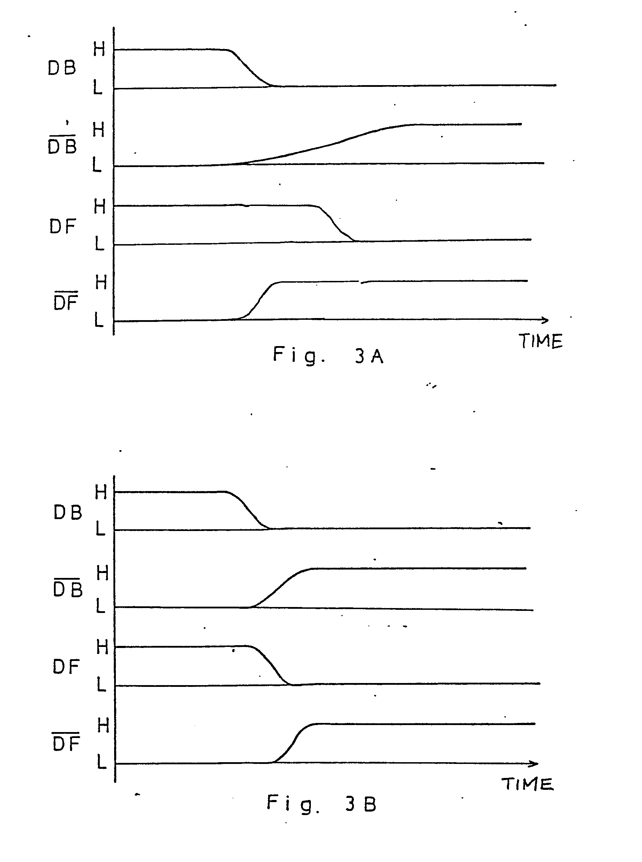

Figures 3A and 3B are signal waveform diagrams showing the variations of data bus line signals DB, $\overline{DB}$ and output signals DF, $\overline{DF}$ in a previously proposed circuit and in an embodiment of the present invention, respectively. The previously proposed circuit does not comprise the charging transistors $Q_{11}$, $Q_{12}$ of Figure 1. In the previously proposed circuit's signal waveforms illustrated in Figure 3A, when data to be read out changes from "H" to "L", the signal DB changes from "H" to "L" rapidly, but the signal $\overline{DB}$ changes from "L" to "H" slowly. The reason for this is that the discharging ability of transistor $Q_7$ ($Q_8$) is better than the charging ability of transistor $Q_6$ ($Q_5$) in general. The slow change is thus attributed to the availability of only a small charging current, and results in a delay in the change of the output DF from "H" to "L". In the embodiment of the present invention, as illustrated in Figure 3B, the signal DB changes from "H" to "L" rapidly, and charging current is consequently increased, so that the rise in signal $\overline{DB}$ is also fast. Also, the signal DF falls faster than in the previously proposed circuit. Although Figure 3B relates to a case in which data to be read out changes from "H" to "L", changes from "L" to "H", or increases in the signals DB and DF are speeded up in the converse case in which data to be read out changes from "L" to "H".

As described above, in the memory circuit embodying the present invention, in accordance with a read-out result, (i.e. read-out data), a charging MOS FET connected to the data bus line on the "H" side turns "ON" and performs a pull-up operation, but the charging MOS FET connected to the data bus line on the "L" side turns "OFF" and has no effect on operations.

The selection of a next memory cell under these conditions will now be considered. It is assumed that the selected cell belongs to the same column as that of the previously selected cell but to a different word line, and that the selected cell stores data the opposite of that stored in the previously selected cell.

The "ON" MOS FET of the selected cell pulls-down the bit line and the data bus line on the "H" side (as determined by the previously selected cell—BL and DB in this case). In this respect, since the presence of MOS FET $Q_{11}$ is to be considered, the pull-down load becomes greater than in the previously proposed circuit. However, the presence of the MOS FET $Q_{11}$ causes no special problems for reasons described hereunder.

Unlike the non-linear type sense amplifier of the previously proposed memory circuit, which does not operate unless a potential difference of the order of ±0.5 V arises, the sense amplifier SA of a memory circuit embodying the present invention is a linear amplifier which has the widest possible range of proportional operation as described above. Therefore, as soon as the bit line and the data bus line begin to change their potential levels, the sense amplifier SA starts operating so as to promote those changes. Moreover, each memory cell, of the specified type, has the transconductance $g_m$ ratio between the driver MOS FET's $Q_7$ and $Q_8$ and the transfer gate MOS FET's $Q_9$, $Q_{10}$ properly selected so that the bit line and the data bus line when close to the power source voltage as viewed from the minute cell, can be pulled down sufficiently. After all, according to the embodiment of the present invention, the transconductance $g_m$ of the data bus load is in effect made high during charging, and low (as usual) during discharging, so that the transconductance $g_m$ of the bit line load can be set in a ratioless form relative to the transconductance $g_m$ of the cell driver. Accordingly, the signal change of the bit line is efficiently speeded up, and read-out speed is enhanced. By the way, read-out outputs are derived by passing the outputs DF and $\overline{DF}$ of the sense amplifier SA through the output buffer OB.

In the illustrated embodiment of the present invention, MOS FET's $Q_5$ and $Q_6$ are used as loads. However, they can be replaced as loads by resistors. Further, whilst MOS FETs have been referred to in the description of the illustrated embodiment, embodiments using other semiconductor devices can be provided.

As set forth above, in an embodiment of the present invention, a bit line load current, in other words a charging current, (which is reduced when the memory has a high memory density) of a memory is changed in response to a signal to be read out, so that fast read-out is achieved even when the transconductance $g_m$ of a cell driver is low.

An embodiment of the present invention provides a high density static RAM integrated circuit comprising a pair of bit lines to which pull-up loads are respectively connected, a plurality of memory cells which are connected across the bit lines of the pair, a pair of data buses which are connected to the pair of bit lines, and a sense amplifier which is connected to the pair of bit lines through the pair of data buses, the pair of data buses being respectively provided with charging circuits each of which has a control terminal for varying the pull-up current applied to the relevant data bus (and bit line), amplified outputs of the sense amplifier being fed back to control terminals of the charging circuits, and the data bus on a high potential side being charged by the corresponding charging circuit. As a result, the current to flow across a common data bus line connected to a higher (potential) side of selected bit lines is increased, thereby enabling a high speed read out operation in the high-density static RAM.

The present invention can provide a fast-access RAM which, when reading out stored data from a memory cell, is operable to change a data bus line load in dependence upon the data to be read out, thereby to provide fast read-out.

**Claims**

1. A static RAM including a memory circuit comprising: a pair of bit lines BL, $\overline{BL}$), to which pull-up loads ($Q5, Q6$) are respectively connected; a plurality of memory cells (MC) each connected to the pair of bit lines; a pair of data bus lines (DB, $\overline{DB}$) operatively connected to the pair of bit lines, and a sense amplifier (SA) connected to the pair of bit lines through the pair of data bus lines; characterised in that the sense amplifier comprises a linear amplifier which delivers complementary outputs (DF, $\overline{DF}$), and in that the memory circuit further comprises charging circuitry ($Q11$, $Q12$) operatively connected to the pair of data bus lines for charging up that one of the pair of data bus lines which is of higher potential, the charging circuitry having control terminals arranged to receive respectively and directly the complementary outputs of the sense amplifier and being activated in dependence upon the said outputs.

2. A memory circuit as claimed in Claim 1, the charging circuitry ($Q11$, $Q12$) comprising respective charging circuits ($Q11$, $Q12$) for the data bus lines of the pair of data bus lines (DB, $\overline{DB}$) the charging circuits having respective control terminals for receiving respective outputs of the sense amplifier (SA) and being operable so that the charging circuit for that one of the pair of data bus lines of the higher potential charges that one data bus line.

3. A memory circuit as claimed in any preceding claim, wherein each memory cell (MC) comprises first to fourth field effect transistors (Q7 to Q10) and first (R1) and second (R2) load elements; the first (Q7) and second (Q8) field effect transistors having their sources arranged for grounding and their drains arranged for connection to a power supply (Vcc) through the first (R1) and second (R2) load elements respectively; the gate of the first field effect transistor (Q7) and the drain of the third field effect transistor (Q9) being connected to the drain of the second field effect transistor (Q8); the gate of the second field effect transistor (Q8) and the drain of the fourth field effect transistor (Q10) being connected to the drain of the first field effect transistor (Q7); and the third (Q9) and fourth (Q10) field effect transistors having their gates connected to a word line (Xo, Xn) of the memory circuit corresponding to the memory cell (MC) concerned and having their sources connected to the respective bit lines (BL, $\overline{BL}$) of the pair of bit lines.

4. A memory circuit as claimed in any preceding claim, wherein a plurality of pairs of bit lines (BL, $\overline{BL}$) are connected to the pair of data bus lines (DB, $\overline{DB}$) through gate circuits (Q1, Q2; Q3, Q4) which correspond respectively to the pairs of bit lines and which have each a switching function.

5. A memory circuit as claimed in any preceding claim, wherein each pull-up load comprises an MIS field effect transistor (Q5, Q6) whose gate and drain are both arranged for connection to a power supply (Vcc).

6. A memory circuit as claimed in any preceding claim, wherein the sense amplifier (Sa) comprises:

first and second field effect transistors (Q15, Q16) of the enhancement mode;

third and fourth field effect transistors (Q13, Q14), of the depletion mode; and

fifth and sixth field effect transistors (Q17, Q18);

the gates of the first and second field effect transistors (Q15, Q16) being connected to respective data bus lines (DB, $\overline{DB}$) of the pair of data bus lines, the sources of the first and second field effect transistors being connected in common to the fifth and sixth field effect transistors (Q17, Q18) which are arranged in parallel for connection to ground with their gates connected to receive respective complementary outputs (DF, $\overline{DF}$) of the sense amplifier (SA), the drains of the first and second field effect transistors (Q15, Q16) being connected to the drains and gates of the third and fourth field effect transistors Q13, Q14) respectively, the said complementary outputs (DF, $\overline{DF}$) being delivered from the drains of the first and second field effect transistors (Q15, Q16) which are also connected respectively to the control terminals of the charging circuits (Q11, Q12), the sources of the third and fourth field ffect transistors (Q13, Q14) being arranged for connection to a power supply (Vcc).

7. A memory circuit as claimed in any preceding claim, wherein each charging circuit comprises a field effect transistor (Q11, Q12) whose drain is arranged for connection to a power supply (VCC), whose source is connected to the corresponding data bus line of the pair of data bus lines (DB, $\overline{DB}$), and those gate is supplied with one of the complementary outputs (DF, $\overline{DF}$) (positive-phase or negative-phase) of the sense amplifier (SA) corresponding to the data bus line to which the source is connected.

**Patentansprüche**

1. Statisches RAM mit einer Speicherschaltung, welche umfaßt: ein Paar von Bitleitungen (BL, $\overline{BL}$), mit denen jeweils Pull-up-Ladungen (Q5, Q6) verbunden sind, einer Vielzahl von Speicherzellen (MC), die jede mit einem Paar von Bitleitungen verbunden sind; ein Paar von Datenbusleitungen (DB, $\overline{DB}$), die wirkungsmäßig mit dem Paar von Bitleitungen verbunden sind, und einen Leseverstärker (SA), der mit dem Paar von Bitleitungen über des Paar von Datenbusleitungen verbunden ist, dadurch gekennzeichnet, daß der Leseverstärker einen linearen Verstärker umfaßt, welcher komplementäre Ausgänge (DF, $\overline{DF}$) liefert, und daß die Speicherschaltung ferner Ladeschaltungsanordnungen (Q11, Q12) umfaßt, die wirkungsmäßig mit dem Paar von Datenbusleitungen verbunden sind, um diejenige von dem Paar von Datenbusleitungen aufzuladen, welche auf höherem Potential ist, wobei die Ladeschaltungsanordnungen Steueraschlüsse haben, die angeordnet sind, um jeweils und direkt die komplementären Ausgänge des Leseverstärkers zu empfangen und in Abhängigkeit von den genannten Ausgängen aktiviert werden.

2. Speicherschaltung nach Anspruch 1, bei welcher die Ladeschaltungsanordnungen (Q11, Q12) jeweilige Ladeschaltungsanordnungen (Q11, Q12) für die Datenbusleitungen des Paares von Datenbusleitungen (DB, $\overline{DB}$) umfassen, wobei die Ladeschaltungen jeweilige Steueranschlüsse zum Empfang jeweiliger Ausgänge des Leseverstärkers (SA) haben und so betreibbar sind, daß die Ladeschaltung für diejenige von dem Paar von Datenbusleitungen mit höherem Poatential diese eine Datenbusleitung lädt.

3. Speicherschaltung nach einem der vorhergehenden Ansprüche, bei der jede Speicherzelle (MC) erste bis vierte Feldeffekttransistoren (Q7 bis Q10) und erste (R1) und zweite (R2) Lastelemente umfaßt; die Sourcen des ersten (Q7) und zweiten (Q8) Feldeffekttransistors zur Erdung angeordnet sind und ihre Drains zur Verbindung mit einer Energieversorgung (Vcc) über das erste (R1) bzw. zweite (R2) Lastelement angeschlossen sind; das Gate des ersten Feldeffekttransistors (Q7) und das Drain des dritten Feldeffekttransistors (Q9) mit dem Drain des zweiten Feldeffekttransistors (Q8) verbunden sind, das Gate des zweiten Feldeffekttransistors (Q8) und das Drain des vierten Feldeffekttransisotrs (Q10) mit dem Drain des ersten Feldeffekttransistors (Q7) verbunden sind, und die Gates des dritten (Q9) und vierten (Q10) Feldeffekttransistors mit einer Wortleitung (X0, Xn) der Speicherschaltung verbunden sind, welche der betreffenden Speicherzelle (MC) entspricht, und ihre Sourcen mit entsprechenden Bitleitungen (BL, $\overline{BL}$) des Paares von Bitleitungen verbunden sind.

4. Speicherschaltung nach einem der vorhergehenden Ansprüche, bei der eine Vielzahl von Paaren von Bitleitungen (BL, $\overline{BL}$) mit dem Paar von Datenbusleitungen (DB, $\overline{DB}$) über Gate-Schaltungen (Q1, Q2; Q3, Q4) verbunden sind, die jeweils den Paaren von Bitleitungen entsprechen und die jeweils eine Schaltfunktion haben.

5. Speicherschaltung nach einem der vorhergehenden Ansprüche, bei der jede Pull-up-Last einen MIS-Feldeffekttransistor (Q5, Q6) umfaßt, dessen Gate und Drain beide zur Verbindung mit einer Energieversorgung (Vcc) angeordnet sind.

6. Speicherschaltung nach einem der vorhergehenden Ansprüche, bei der der Leseverstärker (SA) umfaßt:—

erste und zweite Feldeffekttransistoren (Q15, Q16), vom Anrecherungstyp;

dritte und vierte Feldeffekttransistoren (Q13, Q14), vom Verarmungstyp; und

fünfte und sechste Feldeffekttransistoren (Q17, Q18);

die Gates der ersten und zweiten Feldeffekttransistoren (Q15, Q16) mit entsprechenden Datenbusleitungen (DB, $\overline{DB}$) des Paares von Datenbusleitungen verbunden sind, die Sourcen der ersten und zweiten Feldeffekttransistoren gemeinsam mit fünften und sechsten Feldeffekttransistoren (Q17, Q18) verbunden sind, die parallelel zur Verbindung an Erde angeordnet sind, wobei ihre Gates angeschlossen sind, um jeweils komplementäre Ausgänge (DF, $\overline{DF}$) des Leseverstärkers (SA) zu empfangen, die Drains der ersten und zweiten Feldeffekttransistoren (Q15, Q16) mit den Drains und Gates des dritten bzw. vierten Feldeffekttransistors (Q13, Q14) verbunden sind, die genannten komplementäre Ausgänge (DF, $\overline{DF}$) von den Drains der ersten und zweiten Feldeffekttransistoren (Q15, Q16) geliefert werden, welche ebenfalls mit den Steueranschlüssen der Ladeschaltungen (Q11, Q12) verbunden sind, die Sourcen der dritten und vierten Feldeffekttransistoren (Q13, Q14) zur Verbindung mit einer Energieversorung (Vcc) angeordnet sind.

7. Speicherschaltung nach einem der vorhergehenden Ansprüche, bei der jede Ladeschaltung einen Feldeffekttransistor (Q11, Q12) umfaßt, dessen Drain zur Verbindung mit einer Energieversorgung (Vcc) angeordnet ist, dessen Source mit einer entsprechenden Datenbusleitung des Paares von Datenbusleitungen (DB, $\overline{DB}$ verbunden ist, und dessen Gate einer der komplementären Ausgänge (DF, $\overline{DF}$ (Positivphase oder Negativphase) des Leseverstärkers (SA) zugeführt wird, der der Datenbusleitung entspricht, mit welcher die Source verbunden ist.

**Revendications**

1. Mémore RAM statique incluant un circuit de mémoire comprenant: une paire de fils de bit (BL,

$\overline{BL}$) auxquels des charges élévatrices de tension (Q5, Q6) sont respectivement connectées; un ensemble de cellules de mémoire (MC) connectées chacune à la pair de fils de bit; une paire de lignes de bus de données (DB, $\overline{DB}$) connectées activement à la paire de fils de bit, et un amplificateur de détection (SA) connecté à la paire de fils de bit par l'intermédiaire de la paire de lignes de bus de données; caractérisée en que l'amplificateur de détection comprend un amplificateur linéaire qui délivre des signaux de sortie complémentaires (DF, $\overline{DF}$), et en ce que le circuit de mémoire comprend en outre des circuits de charge (Q11, Q12) connectés activement à la paire de lignes de bus de données pour charger celle de la paire de lignes de bus de données qui est à un potentiel supérieur, les circuits de charge comportant des bornes de commande disposées pour recevoir respectivement et directement les signaux de sortie complémentaires de l'amplificatuer de détection et étant rendus actifs selon les signaux de sortie.

2. Circuit de mémoire selon la revendication 1, dans lequel les circuits de charge (Q11, Q12) sont constitués par des circuits de charge (Q11, Q12) pour les lignes de bus de données de la paire de lignes de bus de données (DB, $\overline{DB}$), les circuits de charge comportant des bornes de commande respectives pour recevoir les signaux de sortie respectifs de l'amplificateur de détection (SA) et pouvant être mis en fonctionnement de sortie que le circuit de charge pour celle de la paire de lignes de bus de données du potentiel supérieur charge cette ligne de bus de données.

3. Circuit de mémoire selon l'une quelconque des revendications 1 et 2, dans lequel chaque cellule de mémoire (MC) comprend des premier à quatrième transistors à effet de champ (Q7 à Q10) et des premier (R1) et second (R2) éléments de charge; le premier (Q7) et le deuxième (Q8) transistors à effet de champ ayant leurs sources disposées pour être reliées à la masse et leurs drains disposés pour une connexion à une source d'alimentation (Vcc) par l'intermédiaire des premier (R1) et second (R2) éléments de charge respectivement; la grille du premier transistor à effet de champ (Q7) et le drain du troisième transistor à effet de champ (Q9) étant connectés au drain du deuxième transistor à effet de champ (Q8); la grille du deuxième transistor à effet de champ (Q8) et le drain du quatrième transistor à effet de champ (Q10) étant connectés au drain du premier transistor à effet de champ (Q7); et les troisième (Q9) et quatrième (Q10) transistors à effet de champ ayant leurs grilles connectées à fil de mot (Xo, Xn) du circuit de mémoire correspondant à la cellule de mémoire (MC) concernée et ayant leurs sources connectés aux fils de bit respectifs (BL, $\overline{BL}$) de la paire de fils de bit.

4. Circuit de mémoire selon l'une quelconque des revendications 1 à 3, dans lequel un ensemble de paires de fils de bit (BL, $\overline{BL}$) sont connectés à la paire de lignes de bus de données (DB, $\overline{DB}$) par l'intermédiaire de circuits à portes (Q1, Q2; Q3, Q4) qui correspondent respectivement aux paires

**0 060 115**

de fils de bit et que ont chacun une fonction de commutation.

5. Circuit de mémoire selon l'une quelconque des revendications 1 à 4, dans lequel chaque charge élévatrice comprend un transistor à effet de champ à métal-isolant-semiconducteur MIS (Q5, Q6) dont la grille et le drain sont tous les deux disposées pour une connexion à une source d'alimentation (Vcc).

6. Circuit de mémoire selon l'une quelconque des revendications 1 à 5, dans lequel l'amplificateur de détection (SA) comprend:

des premier et deuxième transistors à effet de champ (Q15, Q16) du mode à enrichissement;

des troisième et quatrième transistors à effet de champ (Q13, Q14), du mode à appauvrissement; et

des cinquième et sixième transistors à effet de champ (Q17, Q18);

les grilles des premier et deuxième transistors à effet de champs (Q15, Q16) étant connectés aux lignes de bus de données respectives (DB, $\overline{DB}$) de la paire de lignes de bus de données, les sources des premier et deuxième transistors à effet de champ étant connectées en commun aux cinquième et sixième transistors à effet de champ (Q17, Q18) qui sont disposés en parallèle pour une connexion à la masse, leurs grilles étant

connectées pour recevoir des signaux de sortie complémentaires respectifs (DF, $\overline{DF}$) de l'amplificateur de détection (SA), les drains des premier et deuxième transistors à effet de champ (Q15, Q16) étant connectés aux drains et aux grilles des troisième et quatrième transistors à effet de champ (Q13, Q14) respectivement, les signaux de sortie complémentaires (DF, $\overline{DF}$) étant délivrés par les drains des premier et deuxième transistors à effet de champ (Q15, Q16) qui sont également connectés respectivement aux bornes de commande des circuits de charge (Q11, Q12), les sources des troisième et quatrième transistors à effet de champ (Q13, Q14) étant disposées pour une connexion à une source d'alimentation (Vcc).

7. Circuit de mémoire selon l'une quelconque des revendications 1 à 6, dans lequel chaque circuit de charge comprend un transistor à effet de champ (Q11, Q12) dont le drain est disposé pour une connexion à une source d'alimentation (Vcc), dont la source est connectée à la ligne de bus de données correspondante de la paire de lignes de bus de données (DB, $\overline{DB}$), et dont la grille reçoit un des signaux de sortie complémentaires (DF, $\overline{DF}$) (phase positive ou phase négative) de l'amplificateur de détection (SA) correspondant à la ligne de bus de données à laquelle la source est connectée.

Fig. 1

Fig. 2

0 060 115

Fig. 3A

Fig. 3B